Europäisches Patentamt

European Patent Office

Office européen des brevets

(19)

(11) Veröffentlichungsnummer: **0 262 482 B1**

(12) **EUROPÄISCHE PATENTSCHRIFT**

(45) Veröffentlichungstag der Patentschrift: 29.05.91

(51) Int. Cl.⁵: **H05K 7/14**, H05K 7/18

(21) Anmeldenummer: 87113207.2

(22) Anmeldetag: 09.09.87

(54) Gehäuse zur Aufnahme von elektrischen Baugruppenträgern.

(30) Priorität: 30.09.86 DE 3633273

(43) Veröffentlichungstag der Anmeldung:
06.04.88 Patentblatt 88/14

(45) Bekanntmachung des Hinweises auf die
Patenterteilung:
29.05.91 Patentblatt 91/22

(84) Benannte Vertragsstaaten:
AT BE CH DE FR GB IT LI NL

(56) Entgegenhaltungen:
DE-A- 2 842 080
DE-U- 8 509 591
US-A- 3 288 301

(73) Patentinhaber: **Siemens Aktiengesellschaft**
**Wittelsbacherplatz 2**
**W-8000 München 2(DE)**

(72) Erfinder: **Niggl, Heinz-Jürgen, Ing. (grad.)**
**Am Lindenberg 149**
**W-8134 Pöcking(DE)**
Erfinder: **Günther, Thom, Dipl.-Ing.**
**Untertaxetweg 6**
**A-8035 Gauting(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die Erfindung betrifft ein Gehäuse zur Aufnahme von elektrischen Baugruppenträgern, bestehend aus auf einer Standfläche übereinander stapelbaren modularen quaderförmigen Gehäuseeinheiten mit mechanisch stabilen Seitenwänden, die durch an ihren Ober- und Unterseiten parallel zur Standfläche verlaufende Horizontalbefestigungselemente miteinander verbunden sind, zwischen denen die Baugruppen, insbesondere parallel zu den Seitenwänden, lösbar angeordnet sind.

Aus der deutschen Gebrauchsmusterschrift G 8 509 591.5 ist bereits ein Gestell zur Aufnahme von elektrischen Baugruppenträgern bekannt, das aus mehreren einzelnen übereinander stapelbaren Magazinen besteht. Die Magazine weisen mechanisch stabile Seitenwände auf, die durch zu ihnen senkrecht angeordnete Baugruppenträgerholme oben und unten miteinander verbunden sind. Das bekannte Gestell wird durch unmittelbares Aufeinandersetzen der Magazine gebildet, ohne daß besondere Verbindungselemente zwischen benachbarten Magazinen vorgesehen sind. Gehäuse aus mehreren übereinander gestapelten Magazine ohne besondere Verbindungselemente erweisen sich als mechanisch instabil, insbesondere wenn der Schwerpunkt der Gesamtanordnung weit von der Standfläche des Gehäuses entfernt ist.

Ausgehend von diesem Stand der Technik liegt der Erfindung die Aufgabe zugrunde, ein Gehäuse der eingangs genannten Art anzugeben, das auch bei mehreren übereinander gestapelten Gehäuseeinheiten eine hohe mechanische Stabilität aufweist und mit seitlich benachbarten, gleichartigen Gehäusen in einfacher Weise mechanisch verbindbar ist.

Die Lösung dieser Aufgabe erfolgt erfindungsgemäß dadurch, daß die Seitenwände Aufnahmeelemente aufweisen, die derart ausgebildet sind, daß in die Aufnahmeelemente zweier benachbarter Gehäuseeinheiten erste mechanisch starre Verbindungselemente einführbar sind, die so mit einem Abstandshalter versehen sind, daß sie zwischen benachbarten Gehäuseeinheiten einen Schlitz mit im wesentlichen konstanter Breite bilden.

Die Erfindung ist mit dem Vorteil verbunden, daß Gehäuseeinheiten trotz Toleranzen in den benachbarten Seitenwandkanten übereinander angeordnet werden können. Die zwischen die Seitenwandkanten übereinander angeordneten Gehäuseeinheiten gebildeten Schlitze nehmen etwaige Toleranzen auf. Darüber hinaus ermöglichen die Schlitze, daß nebeneinander angeordnete gleichartige Gehäuse mechanisch stabil verbindbar sind, ohne daß Eingriffe, wie etwa Bohrungen zur Herstellung von Schraubverbindungen, in benachbarten Seitenwänden erforderlich sind. Seitlich benachbarte Gehäuse lassen sich leicht voneinander trennen. Die getrennten Gehäuse zeigen nach der Trennung keinerlei Spuren der ursprünglichen Verbindung.

Die Schlitze verleihen dem Gehäuse zusätzlich ein ansprechendes Erscheinungsbild. Neben den genannten mehrfachen technischen Funktionen kommt ihnen also auch eine gestalterische formgebende Funktion zu.

Das Gehäuse gemäß der Erfindung weist kein separates Gestell für die Baugruppenträger auf. Die Seitenwände übernehmen die Funktionen des Baugruppenträgergestells und die üblichen Funktionen der Gehäusewände von Gehäuse elektrischer Einrichtungen, die Abschirmung gegen Fremdspannungen sowie der Schutz vor mechanischen Beschädigungen und Verunreinigungen. Die Zusammenfassung dieser unterschiedlichen Funktionen führt zu raum- und kostensparenden Gehäusen.

Übereinandergestapelte und/oder seitlich benachbarte Gehäuseeinheiten, werden durch die gleichen Verbindungselemente mechanisch stabil und zugleich elektrisch leitfähig miteinander verbunden. Das aus mehreren Einheiten bestehende Gehäuse ist zur Abschirmung aller im Gehäuse angeordneten Baugruppen nur einmal an Masse anzuschließen. Ein Mehrfachanschluß erübrigt sich. Beim Ausbau des Gehäuses durch übereinander oder seitlich nebeneinander anzuordne de Gehäuseeinheiten werden diese jeweils zugleich mechanisch und galvanisch verbunden. Ein separater Anschluß an Masse ist daher nicht vorzusehen.

Die Erfindung wird nun anhand der Zeichnungen beschrieben. Es zeigt:

FIG 1      eine Explosionszeichnung eines aus zwei modularen Gehäuseeinheiten bestehenden Gehäuses;

FIG 2      eine perspektivische Ansicht einer Gehäuseeinheit;

FIG 3      eine Seitenansicht einer dem Inneren der Gehäuseeinheit zugewandten Seitenwand;

FIG 4      die Seitenwände an ihren Ober- und Unterseiten verbindende Platten;

FIG 5      ein erster Schnitt durch die Platte nach FIG 4;

FIG 6      ein zweiter Schnitt durch die Platte nach FIG 4;

FIG 7      weitere konstruktive Einzelheiten der Platte nach FIG 4;

FIG 8      eine Draufsicht auf eine Kante einer Gehäuseeinheit mit einem in einer Seitenwand angeordneten Aufnahmeelement;

FIG 9      ein erstes Verbindungselement zur Verbindung übereinander angeordneter Gehäuseeinheiten;

FIG 10      ein zweites Verbindungselement zur Verbindung seitlich benachbarter Gehäuseeinheiten; und

FIG 11     eine schematische Darstellung von Rückwandplatten übereinandergestapelter Gehäuseeinheiten.

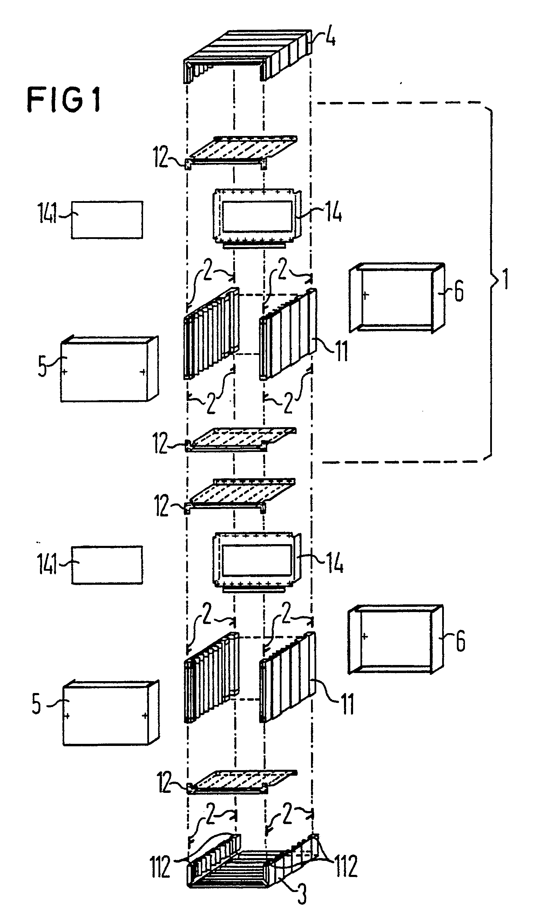

Das Gehäuse gemäß der Erfindung, das insbesondere zur Aufnahme elektrischer Baugruppenträger dient, besteht aus modularen Gehäuseeinheiten 1 mit mechanisch stabilen Seitenwänden 11, aus einer unteren Gehäuseabdeckung 3 und einer oberen Gehäuseabdeckung 4. Das Gehäuse ist aus einer Vielzahl modularer Gehäuseeinheiten 1 aufbaubar. FIG 1 zeigt ein Gehäuse mit zwei modularen Gehäuseeinheiten 1. Die übereinandergestapelten Gehäuseeinheiten 11 werden, wie noch im einzelnen beschrieben wird, durch erste mechanisch starre Verbindungselemente 2 miteinander verbunden.

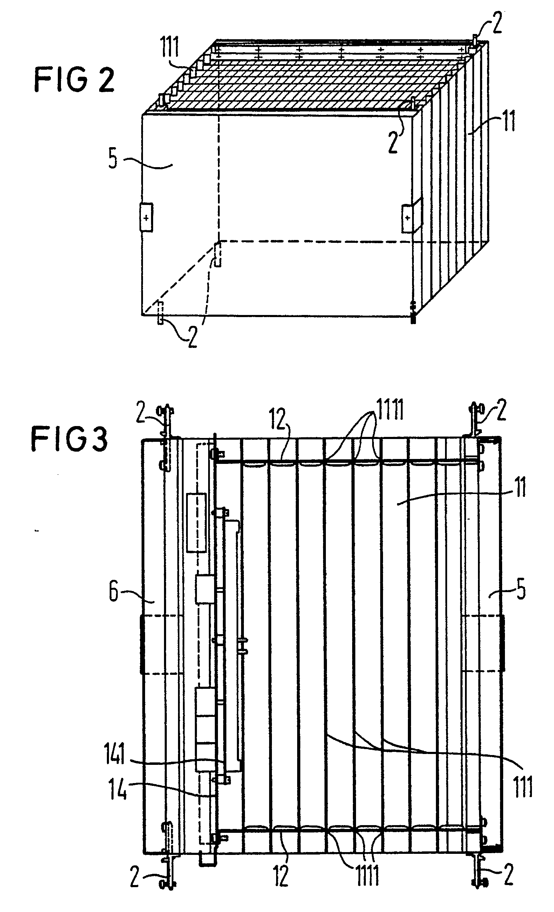

Die auch in den FIG 2 und 3 dargestellten Seitenwände 11, die mechanisch stabil ausgebildet sind, bestehen mindestens teilweise, vorzugsweise ganz aus elektrisch leitfähigem Material und schirmen bei Anschluß an einen Erdkontakt die im Gehäuseinneren angeordneten elektrischen Baugruppen ab. Zur Erhöhung der mechanischen Stabilität weisen die Seitenwände 11 Verstärkungselemente 111 auf. Diese können beispielsweise durch in Stapelrichtung an der Gehäuseinnenwand verlaufende Rippen gebildet werden.

Die Seitenwände 11 sind durch senkrecht zur Stapelrichtung, also parallel zur Gehäusestandfläche verlaufende Horizontalbefestigungselemente fest miteinander verbindbar. Die Horizontalbefestigungselemente können durch Holme oder Platten 12 gebildet werden. Vorzugsweise werden für die Gehäuseeinheiten 1 Platten 12 verwendet, die Führungsschienen 121 zur Aufnahme mit elektrischen Baugruppen bestückbarer plattenförmiger Baugruppenträger aufweisen. Die Horizontalbefestigungselemente beziehungsweise Platten 12 bestehen mindestens teilweise, vorzugsweise ganz aus elektrisch leitfähigem Material. Die durch in Stapelrichtung ausgerichtete Rippen gebildete Verstärkungselemente 111 weisen in der Nähe der Ober- und Unterkante der Seitenwände 11 je einen Horizontalschnitt 1111 auf, der zur Aufnahme der Platte 12 dient.

Das Gehäuse gemäß der Erfindung weist zusätzlich zu den Seitenwänden kein seperates Gestell auf. Vielmehr bilden die mechanisch stabilen Seitenwände zugleich auch das Gestell. Während bei konventionellen Gehäusen zur Aufnahme elektrischer Baugruppenträger mit seperatem Gestell ein Freiraum zwischen Gestell und Gehäusewandung besteht, der zur Entwärmung genutzt werden kann, besteht bei dem Gehäuse beziehungsweise den modularen Gehäuseeinheiten gemäß der Erfindung kein separater Entwärmungsraum. Jedoch weisen die die mechanisch stabilen Seitenwände fest verbindenden Horizontalbefestigungselemente, die insbesondere durch Platten gebildet werden, Entwärmungsöffnungen 122 auf, die ein Abströmen erwärmter Luft aus dem Gehäuse und ein Nachströmen frischer Luft in das Gehäuse in Verbindung mit entsprechenden Öffnungen in der unteren und oberen Gehäuseabdeckung 3 und 4 erlauben. Diese Entwärmungsöffnungen in der unteren beziehungsweise oberen Gehäuseabdeckung 3, 4 befinden sich vorzugsweise an der Gehäuserückseite in der Zeichenebene der FIG 1. In die untere beziehungsweise obere Gehäuseadeckung 3, 4 ist ein erster beziehungsweise zweiter Grill mit Entwärmungsöffnungen einsetzbar.

Die Gehäuseeinheiten 11 können an ihrer Vorderseite durch eine in FIG 1 nicht dargestellte Vorderwandplatte 13 abgeschlossen werden. Die Rückwandplatte 14 wird an der durch horizontale gestrichelte Linien gekennzeichneten Stelle zwischen den Seitenwänden 11 in der Nähe ihrer rückwärtigen Kanten angebracht. Mit der Rückwandplatte 14 ist eine Verdrahtungsplatte 141 verbunden, die auf ihrer dem Gehäuseinneren zugewandten Seite Kontaktelemente zur elektrischen Kontaktierung der elektrischen Baugruppen aufweist. Zwischen der Rückwandplatte 14 und den Kanten der Seitenwände 11 besteht ein freier Raum, der der Aufbewahrung von Kabeln dient.

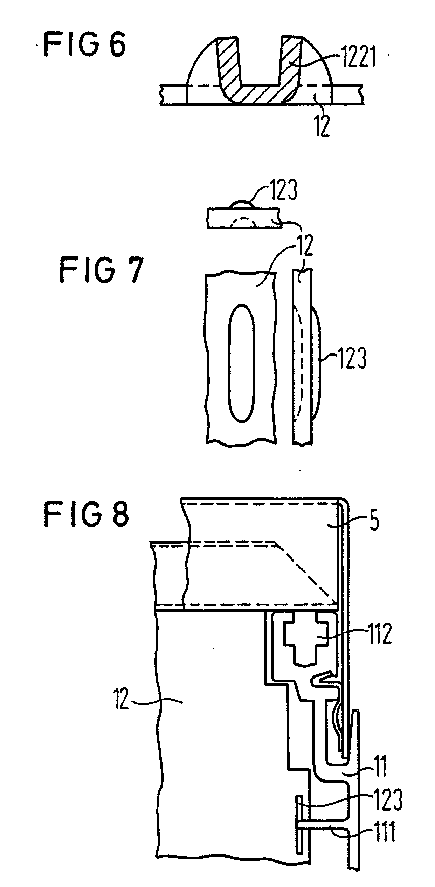

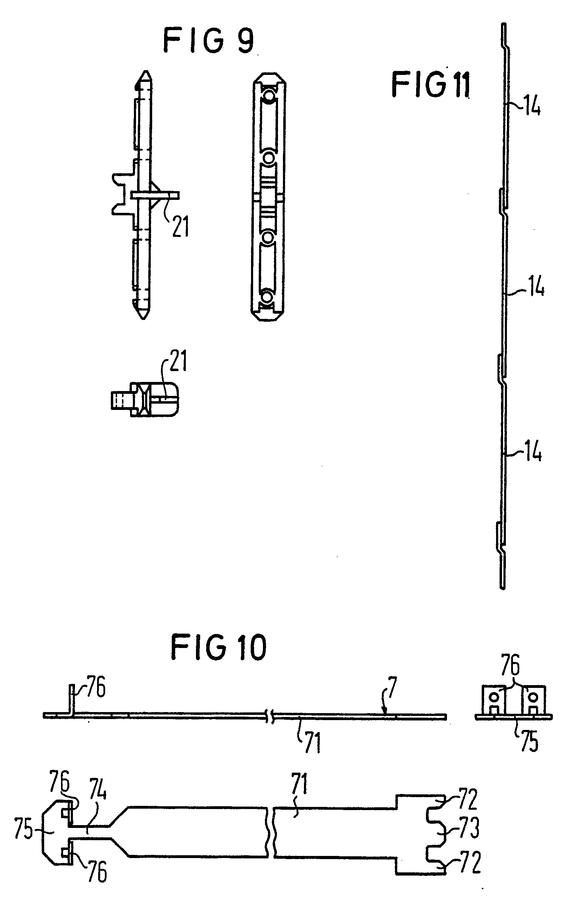

Die Seitenwände 11 weisen, wie noch anhand der FIG 8 und 9 im einzelnen erläutert wird, Aufnahmeelemente 112 auf, die derart ausgebildet sind, daß in die Aufnahmeelemente 112 zweier benachbarter, also übereinandergestapelter Gehäuseeinheiten 1 erste mechanisch starre Verbindungselemente 2 einführbar sind, die so ausgebildet sind, daß sie zwischen benachbarten Gehäuseeinheiten 1 einen Schlitz mit im wesentlichen konstanter Breite bilden. Die ersten mechanisch starren Verbindungselemente sind darüber hinaus zwischen der unteren Gehäuseabdeckung 3 und der darüber angeordneten Gehäuseeinheit 1 sowie zwischen der obersten Gehäuseeinheit 1 des Gehäuses und der darüber angeordneten oberen Gehäuseabdeckung 4 einführbar. Die Gehäuseabdeckungen 3 und 4 weisen also auch Aufnahmeelemente 112 auf.

Die Aufnahmeelemente 112 zur Aufnahme der ersten Verbindungselemente 2 sind vorzugsweise im Bereich der vier Gehäuseecken angeordnet. Die Aufnahmeelemente 112 werden durch sogenannte Mutterkanäle in Stapelrichtung gebildet. Die ersten Verbindungselemente 2 haben eine längliche Form und ragen im montierten Zustand in jeweils zwei benachbarte Gehäuseeinheiten 1 beziehungsweise in die untere Gehäuseabdeckung 3 und die darüber angeordnete Gehäuseeinheit 1 oder in die oberste Gehäuseeinheit 1 des Gehäuses und die obere Gehäuseabdeckung 4. Die ersten Verbindungselemente 2 können vorzugsweise eine Länge aufweisen, die gleich der Höhe der Seitenwände 11 entspricht, wobei in etwa die eine Hälfte der Verbindungselemente 2 in eine und die andere Hälfte der Verbindungselemente 2 in die andere Seitenwand 11 hineinragt. Die erforderliche mechanische Stabilität wird aber bereits mit geringeren Längenabmessungen der ersten Verbindungselemente 2 bewirkt. Vorzugsweise werden für das gesamte Gehäuse erste Verbindungselemente 2 mit gleichen Abmessungen verwendet. Wie FIG 1 zeigt können die untere und obere Gehäuseabdeckung 3, 4 eine geringere Höhe als die Seitenwände 11 aufweisen. Die ersten Verbindungselemente 2 sind, wenn für das gesamte Gehäuse stets gleiche Verbindungselemente 2 verwendet werden, maximal doppelt so lang wie die doppelte Höhe der unteren beziehungsweise oberen Gehäuseabdeckung.

Die für das Gehäuse erforderliche mechanische Stabilität wird bereits mit jeweils drei ersten Verbindungselementen 2 zwischen zwei Gehäuseeinheiten 1 beziehungsweise zwischen einer Gehäuseeinheit 1 und der unteren Gehäuseabdeckung 3 oder der oberen Gehäuseabdeckung 4 erreicht.

Die anhand von FIG 9 im einzelnen beschriebenen ersten Verbindungselemente 2 weisen in ihrem Mittelbereich einen Abstandshalter auf. Die Abstandshalter bilden zwischen benachbarten Gehäuseeinheiten 1 beziehungsweise zwischen der unteren und oberen Gehäuseabdeckung 3, 4 und der benachbarten Gehäuseeinheit 1 jeweils einen Schlitz mit im wesentlichen konstanter Breite. Die Schlitze haben mehrere Funktionen: Zum einen werden Toleranzen in den benachbarten Seitenwandkanten übereinander angeordneter Gehäuseeinheiten optisch reduziert, wobei etwaige Toleranzen durch unterschiedlich hohe Abstandshalter ausgeglichen werden können. Zum anderen lassen sich die Schlitze zur mechanischen Verbindung seitlich benachbarter Gehäuse nutzen. In unmittelbar nebeneinander angeordneten Schlitzen seitlich benachbarter Gehäuse lassen sich zweite Verbindungselemente 7 einführen, die wie anhand von FIG 10 beschrieben wird, die Seitenwände seitlich benachbarter Gehäuse innen umgreifen. Diese als Riegel ausgebildeten zweiten Verbindungselemente 7 können an einer Seite gabelförmig ausgeformt sein.

Die untere und obere Gehäuseabdeckung 3, 4 sowie die Seitenwände 11 bestehen vorzugsweise aus dem gleichen Material und sind mit dem gleichen Innen- und Außenprofil versehen. Die Herstellung erfolgt nach dem gleichen Verfahren, insbesondere nach dem Strangpreßverfahren.

Jede Gehäuseeinheit 1 kann an ihrer Vorderbeziehungsweise Rückseite durch eine vordere Abdeckung 5 beziehungsweise eine hintere Abdeckung 6 abgeschlossen werden. Diese Abdeckungen 5, 6 sind vorzugsweise mittels Schnappverbindungen an den Seitenwänden 11 anbringbar.

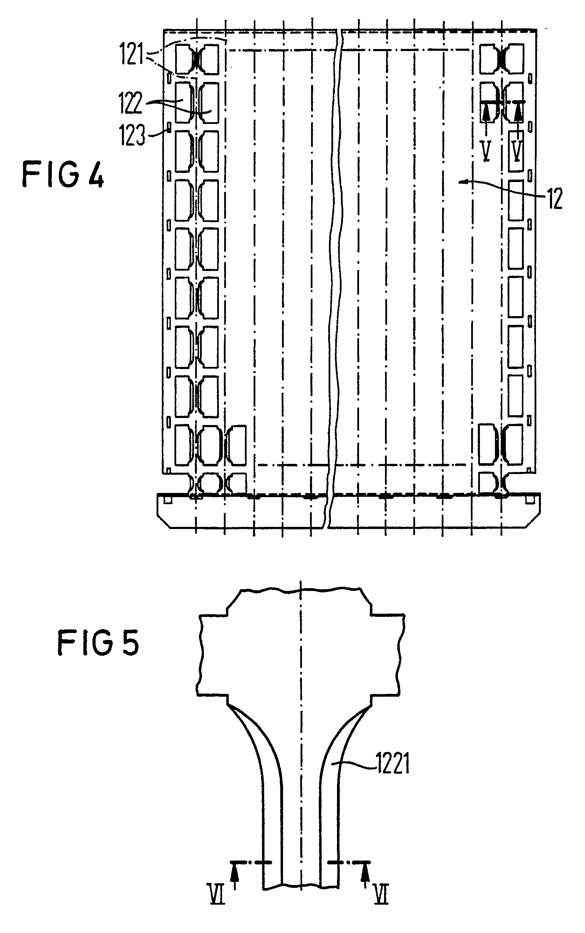

FIG 2 zeigt in perspektivischer Darstellung eine Gehäuseeinheit 1. Erste Verbindungselemente 2 sind sowohl an der Ober-als auch an der Unterseite der Gehäuseeinheit 1 in entsprechenden Aufnahmeelementen eingeführt. Sie ist durch eine vordere beziehungsweise in FIG 2 nicht sichtbare hintere Abdeckung 5, 6 abgeschlossen. Nach oben wird die Gehäuseeinheit 1 durch eine Platte 12 abgeschlossen, die wie noch anhand von FIG 4 erläutert wird parallel zu den Seitenwänden 11 verlaufende Führungsschienen für die Baugruppenträger und Entwärmungsöffnungen aufweist. Die Platte 12 lagert in Horizontalschnitten, die sich in den Verstärkungselementen 111 der Seitenwände 11 befinden.

FIG 3 veranschaulicht für eine Gehäuseeinheit die Zuordnung von Seitenwand 11, einen oberen und unteren plattenförmigen Horizontalbefestigungselement, Rückwandplatte 14, vordere beziehungsweise hintere Abdeckung 5, 6 sowie von ersten Verbindungselementen 2.

An der Innenseite der in FIG 3 dargestellten Seitenwand 11 verlaufen Verstärkungselemente 111 in Stapelrichtung, also senkrecht zur Standfläche des Gehäuses. In Horizontalschnitten 1111 der Verstärkungselementen 11 sind die Platten fest gelagert, die Führungsschienen für die elektrischen Baugruppen aufweisen. Die Baugruppen werden von der Vorderseite des Gehäuses (rechts in FIG 3) in Richtung der Rückseite des Gehäuses (links in FIG 3) bis zum Anschlag an die Verdrahtungsplatte 141 geschoben, die an der Rückwandplatte 14 befestigt wird. An der Verdrahtungsplatte 141 sind zur Vorderseite der Gehäuseeinheit 1 geöffnete Steckverbindungsleisten befestigt. Diese Steckverbindungsleisten weisen Kontaktstifte auf, die in Stiftaufnahmeelemente der elektrischen Baugruppen eingreifen. Die Steckverbindungsleisten einer Gehäuseeinheit 1 sind untereinander sowie mit den Steckverbindungsleisten anderer Gehäuseeinheiten über Kabel miteinander verbindbar, die im rückwärtigen durch die Rückwandplatten begrenzten Raum der Gehäuseeinheiten geführt werden.

Die in FIG 3 dargestellte Gehäuseeinheit 1 ist an ihrer Vorderbeziehungsweise Rückseite mit jeweils einer Abdeckung 5 beziehungsweise 6 abgeschlossen.

In der Seitenwand 11 sind zur Verbindung mit je einer weiteren Gehäuseeinheit 1 beziehungsweise mit der unteren und/oder oberen Gehäuseabdeckung 3, 4 an der Ober- und Unterkante der Seitenwand erste Verbindungselemente 2 eingeführt.

FIG 4 veranschaulicht die Form und Anordnung der Führungsschienen 121 für die elektrischen Baugruppenträger und der Entwärmungsöffnungen 122 in der Platte 12. Die Entwärmungsöffnungen 122 sind in zu den Seitenwänden 11 parallelen Reihen angeordnet und weisen in das Innere der jeweiligen Gehäuseeinheit 1 ausgerichtete Kragen 1221 auf, die so ausgeformt sind, daß die Kragen 1221 benachbarter Reihen jeweils eine Führungsschiene 121 bilden. Die Form der Kragen 1221 ist in den FIG 5 und 6 dargestellt.

Die Platte 12 weist an den Seiten, an denen sie mit den Seitenwänden 11 zu verbinden ist, Warzen 123 auf, die eine galvanische Verbindung zwischen der Platte 12 und den Seitenwänden 11 herstellen, indem sie in den Horizontalschnitten 1111 (FIG 3) gegen die Verstärkungselemente 111 drücken. Die Form der Warzen ergibt sich aus FIG 7.

FIG 5 und 6 zeigen eine mögliche Form des Kragens 1221. Herstellungstechnisch werden die Kragen 1221 gebildet, in dem ursprünglich durchgehende Platten im Bereich der späteren Entwärmungsöffnungen 122 entlang der parallel zu den späteren Führungsschienen 121 verlaufenden Mittelachse der Entwärmungsöffnungen 122 und deren senkrecht hierzu verlaufenden Seiten eingeschnitten werden (FIG 4). Die eingeschnittenen Teile werden anschließend senkrecht zur Platte gebogen (?). Die beiden in FIG 5 dargestellen Kragen 1221 sind also Material gebildet, das sich ·ursprünglich im Bereich später gebildeter benachbarter Entwärmungsöffnungen befindet (?). Die Kragen 1221 benachbarter, zu den Seitenwänden paralleler Reihen bilden Führungsschienen für die elektrischen Baugruppen. Jeweils zwei Kragen 1221 benachbarter Reihen von Entwärmungsöffnungen bilden einen senkrecht zur Platte (12) stehenden und sich zur Platte (12) verengenden Schaft. Die Baugruppenträger werden in dem durch die Kragen 1221 gebildeten Schaft gehalten. Die Verengung des Schafts unterstützt den festen Sitz der Baugruppenträger.

FIG 7 zeigt die Form der auf der Platte 12 angeordneten Warzen 123. Die Warzen 123 haben eine längliche Form. Sie sind parallel zu den Seitenwänden 11 der Gehäuseeinheit 1 angeordnet. Seitenwände 11 und Platte 12 bestehen mindestens teilweise aus einer elektrisch leitfähigem Metallschicht. Die Warzen 123 stellen die galvanische Verbindung zwischen den elektrisch leitfähigen Schichten beider Komponenten her. Die Platte 12 lagert im Bereich der Warzen in den Horizontalschnitten 1111 der Verstärkungselemente 11. Die Warzen 123 sind geometrisch so bemessen, daß selbst bei Toleranzen im Horizontalschnitt 1111 und/oder der Platte 12 der gewünschte elektrische Kontakt hergestellt wird. Bei Anschluß an einen Erdkontakt sind die im Inneren einer Gehäuseeinheit angeordneten elektrische Baugruppen gegen Fremdspannungen abgeschirmt.

Die Abschirmung erfolgt durch die Seitenwände 11, die obere und untere Platte 12, sowie die Rückwandplatte 14 in Verbindung mit der Verdrahtungsplatte 141. Die Abschirmung kann durch eine vordere und hintere Abdeckung 5, 6 sowie die untere und obere Gehäuseabdeckung 3, 4 ergänzt werden.

FIG 8 veranschaulicht das Zusammenwirken einer Seitenwand 11, die ein Aufnahmeelement 112 aufweist, mit einer horizontalen Platte 12 und mit einer vorderen Gehäuseeinheitabdeckung 5. Die Platte 12 ist in die senkrecht zur Stapelrichtung verlaufenden Verstärkungselemente 111 eingeschoben. Die Warzen 123 unterstützen den festen Sitz der Platte 12 und gewährleisten den elektrischen Kontakt zwischen Platte 12 und Seitenwand 11.

Die hintere Gehäuseabdeckung 6 ist in eine besondere Öffnung in der Seitenwand 11 eingeschoben und wird dort von einer Feder gehalten. Das Aufnahmeelement 112 befindet sich unmittelbar an der Kante der Seitenwand 11. Es besteht aus einem in Stapelrichtung verlaufenden Kanal, der zur Außenseite der Gehäuseeinheit 1 geöffnet ist und die Verschraubung des in FIG 9 dargestellten ersten Verbindungselements 2 erlaubt. Die Länge des Kanals ist mindestens gleich der halben Länge des ersten Verbindungselements 2. Vorzugsweise ist der Kanal über die gesamte Höhe der Gehäuseeinheit 1 ausgebildet.

FIG 9 zeigt einen Querschnitt, eine Vorder- und eine Draufsicht eines ersten Verbindungselements 2. Das Verbindungselement 2 ist symmetrisch zu der eingezeichneten horizontalen Mittelachse ausgebildet. Das Verbindungselement 2 besteht aus einem mechanisch stabilen und elektrisch leitfähigen Körper. Es realisiert die erforderliche mechanische Stabilität übereinandergestapelter Gehäuseeinheiten 1 und stellt die zur Abschirmung gegen Fremdspannungen erforderliche elektrische Verbindung zwischen den Gehäuseeinheiten 1 her. Der Querschnitt des Verbindungselements 2 ist dem in FIG 8 dargestellten Querschnitt des Aufnahmeelements 112 angepaßt, so daß zwei benachbarte, durch Verbindungselemente 2 verbundene Gehäuseeinheiten 1 mechanisch stabil verbunden werden.

Das erste Verbindungselement 2 weist senkrecht zu seiner Längsachse in seiner Mitte einen in den Körper integrierbaren Abstandshalter 21 auf. Dieser bildet mit den Abstandshaltern 21 anderer Verbindungselemente 2, die entweder auf der Ober- oder Unterseite einer Gehäuseeinheit angebracht sind, einen Schlitz mit im wesentlichen konstanter Breite.

Das erste Verbindungselement 2 weist ferner Öffnungen für Schrauben auf. Das in FIG 9 dargestellte Verbindungselement enthält vier derartige Öffnungen. Die Schraubverbindung erfolgt mittels entsprechender Schrauben und Befestigungsmuttern, die an der nach außen geöffneten Seite des kanalförmigen Aufnahmeelements 112 angeordnet werden.

Das in FIG 10 dargestellte zweite Verbindungselement 7 dient der mechanischen und zum Zwekke der Abschirmung der elektrischen Verbindung zweier benachbarter aus Gehäuseeinheiten 1 bestehender Gehäuse und besteht aus einem flachen Riegel, der in die durch die Abstandshalter 21 gebildeten Schlitze seitlich benachbarter Gehäuse eingeschoben wird. Der Riegel 7 besteht aus einem Hauptkörper 71 mit einer gabelförmig ausgebildeten Seite. Die Gabel besteht aus drei Zinken. Die beiden äußeren Zinken 72 umgreifen jeweils im Gehäuseinneren eine Seitenwand, während eine dritte mittlere Zinke 73 zwischen die Seitenwände seitlich benachbarter Gehäuse greift. Im montierten Zustand befinden sich die in den Aufnahmeelementen 112 befestigten ersten Verbindungselemente 2 zwischen einer äußeren (72) und der mittleren (73) beziehungsweise der mittleren (73) und der anderen äußeren Gabelzinke 72.

Der Riegel 7 verjüngt sich an der der gabelförmigen Seite gegenüberliegenden Seite in eine Zunge 74, deren Breite gleich dem Abstand zwischen benachbarten Gehäuseeinheiten entspricht. Ein sich an die Zunge 74 anschließendes Kopfteil 75 weist zwei vertikale Befestigungselemente 76 auf, die wie die ersten Verbindungselemente 2 mit den kanalförmigen Aufnahmeelementen 112 verschraubbar sind.

Die zweiten Verbindungselemente 7 sind ebenso wie die ersten Verbindungselemente 2 in das System zur Abschirmung der elektrischen Baugruppen gegen Fremdspannungen einbezogen und bestehen daher ebenfalls aus elektrisch leitfähigem Material.

FIG 11 veranschaulicht die Ausformung der Rückwandplatten 14 senkrecht zu den Seitenwänden 11 und das Zusammenwirken mehrerer Rückwandplatten 14 übereinandergestapelter Gehäuseeinheiten 1. Rückwandplatte 14 ist so ausgebildet, daß sie mit der Rückwandplatte 14 einer benachbarten Gehäuseeinheit 1 eine mechanisch stabile Verbindung bildet. Die Rückwandplatte 14 jeder Gehäuseeinheit bildet an ihrer Ober- und Unterkante eine Laschung mit der Rückwandplatte 14 der räumlich über- und untergeordneten Gehäuseeinheit 1. Die Rückwandplatten bestehen vorzugsweise aus elektrisch leitfähigen Material und schirmen bei Anschluß an einen Erdkontakt die im Inneren der Gehäuseeinheiten 1 angeordneten elektrischen Baugruppen gegen Fremdspannungen ab.

Ganz allgemein gilt, daß sowohl die jeweils zu einer Gehäuseeinheit verbundenen Komponenten als auch die zu dem erfindungsgemäßen Gehäuse miteinander verbundenen Gehäuseeinheiten zugleich eine mechanisch stabile und eine möglichst großflächige elektrische Verbindung aufweisen. Die elektrisch verbundenen Komponenten bilden ein umfassendes System zur Abschirmung des Gehäuseinneren gegen Fremdspannungen.

## Ansprüche

1. Gehäuse zur Aufnahme von elektrischen Baugruppenträgern, bestehend aus auf einer Standfläche übereinander stapelbaren modularen quaderförmigen Gehäuseeinheiten (1) mit mechanisch stabilen Seitenwänden (11), die durch an ihren Ober- und Unterseiten parallel zur Standfläche verlaufende Horizontalbefestigungselemente (12) miteinander verbunden sind, zwischen denen die Baugruppenträger, insbesondere parallel zu den Seitenwänden (11), lösbar angeordnet sind,
dadurch gekennzeichnet, daß die Seitenwände Aufnahmeelemente (112) aufweisen, die derart ausgebildet sind, daß in die Aufnahmeelemente (112) zweier benachbarter Gehäuseeinheiten (1) erste mechanisch starre Verbindungselemente (2) einführbar sind, die so mit einem Abstandshalter (21) versehen sind, daß sie zwischen benachbarten Gehäuseeinheiten (1) einen Schlitz mit im wesentlichen konstanter Breite bilden.

2. Gehäuse nach Anspruch 1,
dadurch gekennzeichnet, daß die Aufnahmeelemente (112) im Bereich der vier Gehäuseecken angeordnet sind.

3. Gehäuse nach einem der vorhergehenden Ansprüche,
dadurch gekennzeichnet, daß die Seitenwände (11) an ihrer Innenseite in Stapelrichtung verlaufende Verstärkungselemente (111) aufweisen, die im Bereich der Ober- und Unterkanten der Seitenwände (11) mit den Horizontalbefestigungselementen (12) verbindbar sind.

4. Gehäuse nach Anspruch 3,
dadurch gekennzeichnet, daß die Verstärkungselemente (111) im Bereich der Ober- und Unterkanten der Seitenwände (11) je einen horizontalen Schnitt (1111) aufweisen, der die Horizontalbefestigungselemente (12) aufnimmt.

5. Gehäuse nach einem der vorhergehenden Ansprüche,
dadurch gekennzeichnet, daß die Seitenwände (11) mindestens teilweise aus einer elektrisch leitfähigen Metallschicht bestehen.

6. Gehäuse nach Anspruch 5,
**dadurch gekennzeichnet,** daß die Horizontalbefestigungselemente (12) mindestens teilweise aus einer elektrisch leitfähigen Metallschicht bestehen.

7. Gehäuse nach Anspruch 5 und 6,
**dadurch gekennzeichnet,** daß die Metallschicht der Seitenwände (11) und die Metallschicht der Horizontalbefestigungselemente (12) galvanisch miteinander verbindbar sind.

8. Gehäuse nach Anspruch 7,
**dadurch gekennzeichnet,** daß die Horizontalbefestigungselemente (12) an den Kontaktstellen mit den Seitenwänden (11) im Bereich der horizontalen Schnitte (1111) Warzen (123) aufweisen, die gegen die Verstärkungselemente (111) der Seitenwände (11) drücken und damit den galvanischen Kontakt zwischen Horizontalbefestigungselement (12) und Seitenwänden (11) herstellen.

9. Gehäuse nach einem der vorhergehenden Ansprüche,
**dadurch gekennzeichnet,** daß die Gehäuseeinheiten (1) jeweils eine Rückwandplatte (14) aufweisen, die so ausgebildet ist, daß zwei Rückwandplatten (14) benachbarter Gehäuseeinheiten (1) eine mechanisch stabile und eine elektrische Verbindung bilden.

10. Gehäuse nach Anspruch 9,
**dadurch gekennzeichnet,** daß die Rückwandplatte (14) jeder Gehäuseeinheit (1) an ihrer Ober- und Unterkante eine Laschung mit der Rückwandplatte (14) der räumlich über- und untergeordneten Gehäuseeinheit (1) bildet.

11. Gehäuse nach einem der Ansprüche 2 bis 10,
**dadurch gekennzeichnet,** daß zur mechanischen und/oder elektrischen Verbindung zweier seitlich benachbarter Gehäuse in die in gleicher Höhe angeordneten Schlitze jedes Gehäuses zweite Verbindungselemente (7) einführbar sind, die die benachbarten Seitenwände (11) beider Gehäuse umgreifen.

12. Gehäuse nach einem der vorhergehenden Ansprüche,
**dadurch gekennzeichnet,** daß die Horizontalbefestigungselemente (12) aus jeweils einer Führungsschienen (121) für die Baugruppenträger und Entwärmungsöffnungen (122) aufweisenden Platte bestehen.

13. Gehäuse nach Anspruch 11,
**dadurch gekennzeichnet,** daß die Entwärmungsöffnungen (122) in zu den Seitenwänden (11) parallelen Reihen angeordnet sind und in das Innere der jeweiligen Gehäuseeinheit (1) ausgerichtete Kragen (1221) aufweisen, die so ausgeformt sind, daß die Kragen (1221) benachbarter Reihen von Entwärmungsöffnungen (122) jeweils eine Führungsschiene (121) bilden.

14. Gehäuse nach Anspruch 13,
**dadurch gekennzeichnet,** daß jeweils zwei Kragen (1221) benachbarter Reihen von Entwärmungsöffnungen einen senkrecht zur Platte stehenden und sich zur Platte verengenden Schaft bilden.

**Claims**

1. Housing for receiving electrical assembly carriers, consisting of modular, parallelepiped-shaped housing units (1), which can be stacked one above another on a base surface and have mechanically stable side walls (11), which are connected to one another by horizontal fixing elements (12), which extend at their upper and lower sides parallel to the base surface and between which the assembly carriers, preferably parallel to the side walls (11), are detachably arranged, characterised in that the side walls have receiving elements (112) which are designed in such a way that it is possible to introduce into the receiving elements (112) of two adjacent housing units (1) first mechanically rigid connecting elements (2) which are provided with a spacer (21) in such a way that between adjacent housing units (1) they form a slot of substantially constant width.

2. Housing according to Claim 1, characterised in that the receiving elements (112) are arranged in the region of the four housing corners.

3. Housing according to one of the preceding claims, characterised in that on the interior faces the side walls (11) have reinforcing elements (111), which extend in the stacking direction and can be connected in the region of the upper and lower edges of the side walls (11) to the horizontal fixing elements (12).

4. Housing according to Claim 3, characterised in that in the region of the upper and lower edges of the side walls (11) the reinforcing elements (111) each have a horizontal cut (1111) which accommodates the horizontal fixing elements (12).

5. Housing according to one of the preceding claims, characterised in that the side walls (11) consist at least partially of an electrically conductive metal layer.

6. Housing according to Claim 5, characterised in that the horizontal fixing elements (12) consist at least partially of an electrically conductive metal layer.

7. Housing according to Claims 5 and 6, characterised in that the metal layer of the side walls (11) and the metal layer of the horizontal fixing elements (12) can be connected electrically to one another.

8. Housing according to Claim 7, characterised in that at the points of contact with the side walls (11) the horizontal fixing elements (12) are provided in the region of the horizontal cuts (1111) with embossments (123), which press against the reinforcing elements (111) of the side walls (11) and thus establish electrical contact between the horizontal fixing element (12) and side walls (11).

9. Housing according to one of the preceding claims, characterised in that the housing units (1) each have a rear wall plate (14), which is designed such that two rear wall plates (14) of adjacent housing units (1) form a mechanically stable and an electrical connection.

10. Housing according to Claim 9, characterised in that at its upper and lower edge the rear wall plate (14) of each housing unit (1) forms a link with the rear wall plate (14) of the housing unit (1) arranged above and below in space.

11. Housing according to one of Claims 2 to 10, characterised in that for the purpose of mechanically and/or electrically connecting two laterally adjacent housings, second connecting elements (7), which embrace the adjacent side walls (11) of the two housings can be introduced into the slots of each housing, which are arranged at the same point.

12. Housing according to one of the preceding claims, characterised in that the horizontal fixing elements (12) each consist of a plate having guide rails (121) for the assembly carriers and cooling openings (122).

13. Housing according to Claim 11, characterised in that the cooling openings (122) are arranged in rows parallel to the side walls (11) and have collars (1221), which are directed into the interior of the respective housing unit (1) and are shaped such that the collars (1221) of adjacent rows of cooling openings (122) each form a guide rail (121).

14. Housing according to Claim 13, characterised in that in each case two collars (1221) of adjacent rows of cooling openings form a shaft which is perpendicular to the plate and tapers towards the plate.

## Revendications

1. Boîtier destiné à loger des porte-modules électriques, constitué par des unités parallélépipédiques modulaires (1) pouvant être empilées les unes sur les autres sur une surface de support et comportant des parois latérales (11) stables du point de vue mécanique et raccordées entre elles par des éléments de fixation horizontaux (12), qui s'étendent au niveau des côtés supérieur et inférieur des parois, parallèlement à la surface de support et entre lesquelles les porte-modules sont disposés d'une manière amovible, en étant notamment parallèles aux parois latérales (11),
caractérisé par le fait que les parois latérales comportent des éléments récepteurs (112) agencés de telle sorte qu'on peut insérer, dans les éléments récepteurs (112) de deux unités (1) du carter voisines, des premiers éléments de liaison (2) rigides du point de vue mécanique, qui sont équipés d'une entretoise (21) de manière à délimiter, entre des unités voisines (1) du carter, une fente possédant une largeur sensiblement constante.

2. Boîtier suivant la revendication 1, caractérisé par le fait que les éléments récepteurs (112) sont disposés au niveau des quatre coins du boîtier.

3. Boîtier suivant l'une des revendications précédentes, caractérisé par le fait que les parois latérales (11) comportent, au niveau de leur face intérieure, des éléments de renforcement (111), qui s'étendent dans la direction d'empilage et peuvent être raccordés aux éléments de fixation horizontaux (12) au niveau des bords supérieur et inférieur des parois latérales (11).

4. Boîtier suivant la revendication 3, caractérisé par le fait que les éléments de renforcement (111) comportent, au niveau des bords supérieur et inférieur des parois latérales (11), des découpes horizontales respectives (1111), qui reçoivent les éléments de fixation horizontaux (12).

5. Boîtier suivant l'une des revendications précédentes, caractérisé par le fait que les parois latérales (11) sont constituées au moins en partie par une couche métallique électriquement conductrice.

6. Boîtier suivant la revendication 5, caractérisé par le fait que les éléments de fixation horizontaux (12) sont constitués au moins en partie par une couche métallique électriquement conductrice.

7. Boîtier suivant les revendications 5 et 6, caractérisé par le fait que la couche métallique des parois latérales (11) et la couche métallique des éléments de fixation horizontaux (12) peuvent être raccordées entre elles galvaniquement.

8. Boîtier suivant la revendication 7, caractérisé par le fait que les éléments de fixation horizontaux (12) possèdent, au niveau des points de contact avec les parois latérales (11), au niveau des découpes horizontales (1111), des boutons (123), qui appuient contre les éléments de renforcement (111) des parois latérales (11) et par conséquent établissent le contact galvanique entre un élément de fixation horizontal (12) et des parois latérales (11).

9. Boîtier suivant l'une des revendications précédentes, caractérisé par le fait que les unités (1) du boîtier comportent chacune une plaque formant paroi arrière (14), qui est agencée de telle sorte que deux des plaques formant parois arrière (14) d'unités voisines (1) du boîtier établissent une liaison stable du point de vue mécanique et une liaison électrique.

10. Boîtier suivant la revendication 9, caractérisé par le fait que la plaque formant paroi arrière (14) de chaque unité (1) du boîtier établit, au niveau de son bord supérieur et de son bord inférieur, une liaison avec la plaque formant paroi arrière (14) de l'unité (I) du boîtier située au-dessus ou au-dessous d'elle dans l'espace.

11. Boîtier suivant l'une des revendications 1 à 10, caractérisé par le fait que pour réaliser la liaison mécanique et/ou électrique de deux boîtiers latéralement voisins, on introduit, dans les fentes de chaque boîtier situées à une même hauteur, deux éléments de liaison (7), qui enserrent les parois latérales voisines (11) de deux bcîtiers.

12. Boîtier suivant l'une des revendications précédentes, caractérisé par le fait que les éléments de fixation horizontaux (12) sont constitués respectivement par une plaque comportant des rails de guidage (121) pour les porte-modules, et des ouvertures de dissipation thermique (122).

13. Boîtier suivant la revendication 11, caractérisé par le fait que les ouvertures de dissipation thermique (122) sont disposées suivant des rangées parallèles aux parois latérales (11) et comportent des collerettes (1221) dirigées vers l'intérieur de l'unité respective (1) du boîtier et conformées de manière que les collerettes (1221) de rangées voisines d'ouvertures de dissipation thermique (122) forment respectivement un rail de guidage (121).

14. Boîtier suivant la revendication 13, caractérisé par le fait que respectivement deux collerettes (1221) de rangées voisines d'ouvertures de dissipation thermique délimitent un passage perpendiculaire à la plaque et se rétrécissant en direction de cette dernière.

FIG 1

FIG 2

FIG 3

FIG 4

FIG 5

FIG 6

1221

12

FIG 7

123

12

123

FIG 8

5

112

12

11

123

111

# FIG 9

21

21

# FIG 11

14

14

14

# FIG 10

76

7

71

76

75

76   74

75

71

72

73

72

76